# FASCICULE DE BREVET EUROPEEN

(11) **EP 0 549 411 B1**
(45) Date de publication et mention de la délivrance du brevet: **26.04.1995**
(21) Numéro de dépôt: 92403411.9
(22) Date de dépôt: 15.12.1992
(51) Int. Cl.: H03D 7/18

(54) **Procédé et dispositif de transposition de fréquence**
Verfahren und Anordnung zur Frequenzumsetzung
Frequency converter and method therefor

(30) Priorité: 23.12.1991 FR 9116041
(43) Date de publication de la demande: 30.06.1993
(73) Titulaire: THOMCAST, 78700 Conflans-Sainte-Honorine (FR)
(72) Inventeur: Martineau, Didier, F-92402 Courbevoie Cédex (FR)
(74) Mandataire: Courtellemont, Alain

(56) Documents cités:
- EP-A- 0 324 897
- EP-A- 0 347 761
- US-A- 5 033 110
- 16th European Microwave Conference, Dublin, 8th-12th September 1986, pages 157-163, Tunbridge Wells, GB. Wolgang Schiller: LINEARITY UPCONVERTER WITH ULTRA LOW DISTORTION

## Description

La présente invention se rapporte à la transposition de fréquence avec rejet de la composante à la fréquence de l'oscillateur local qui a permis la transposition.

La transposition de fréquence est effectuée par mélange entre un signal d'entrée à une fréquence qui est généralement dite fréquence intermédiaire, et un signal, dit à fréquence locale, fourni par un oscillateur local ; cette transposition fournit une première composante qui est le signal utile, une deuxième composante à la fréquence locale et. une troisième composante qui est une image de la première composante par rapport à la deuxième composante ; le mot image signifie ici que les différences entre la fréquence locale et les fréquences de la première et de la troisième composante, sont de même valeur absolue mais de signes contraires.

Etant donné que la première composante qui est la composante utile doit être obtenue seule, il est connu d'affaiblir fortement les deux autres composantes au moyen d'un filtre disposé à la sortie du mélangeur qui a effectué la transposition ; ce filtre est un filtre passe-bande centré sur la fréquence du signal utile qui sera dite fréquence utile et atténuant les signaux à la fréquence locale et à la fréquence de la composante image qui sera dite fréquence image. Le rejet de la fréquence locale est le plus difficile car, des deux fréquences à rejeter, c'est elle qui est la plus proche de la fréquence utile.

Le but de la présente invention est de rejeter automatiquement la fréquence de l'oscillateur local après une transposition de fréquence afin que le filtre passe-bande de sortie du dispositif de transposition n'ait plus à filtrer que la composante image.

Ceci est obtenu par asservissement, en élaborant, à partir du signal de sortie du filtre passe-bande, un signal sensiblement de même amplitude que la deuxième composante du signal de sortie du mélangeur mais en opposition de phase avec cette deuxième composante, et en ajoutant le signal ainsi élaboré au signal provenant du mélangeur et arrivant sur le filtre passe-bande.

Selon l'invention, il est proposé un procédé de transposition d'une fréquence qui sera dite fréquence intermédiaire par une fréquence qui sera dite fréquence locale pour obtenir une fréquence utile, consistant à mélanger des signaux à fréquence intermédiaire et à fréquence locale pour donner un signal résultant comportant une première composante à la fréquence utile, une deuxième composante à la fréquence locale et une troisième composante qui est une image de la première composante par rapport à la deuxième composante, et à effectuer un filtrage passe-bande du signal résultant, caractérisé en ce qu'il consiste également à ajouter, avant filtrage, au signal résultant, un signal de correction correspondant à la deuxième composante déphasée de 180° et, pour cela, à prélever une partie du signal après filtrage, à créer par intermodulation à partir du signal prélevé une composante auxiliaire à la fréquence intermédiaire, à prélever une partie du signal à fréquence locale et, en fonction de la valeur de la composante auxiliaire, à amplifier et déphaser le signal à fréquence locale prélevé, pour en faire le signal de correction.

La présente invention sera mieux comprise et d'autres caractéristiques apparaîtront à l'aide de la description ci-après et des figures s'y rapportant qui représentent :
- la figure 1 un dispositif de transposition de fréquence selon l'art antérieur
- la figure 2 un dispositif de transposition de fréquence selon l'invention.

Sur les figures les éléments correspondants sont désignés par les mêmes repères.

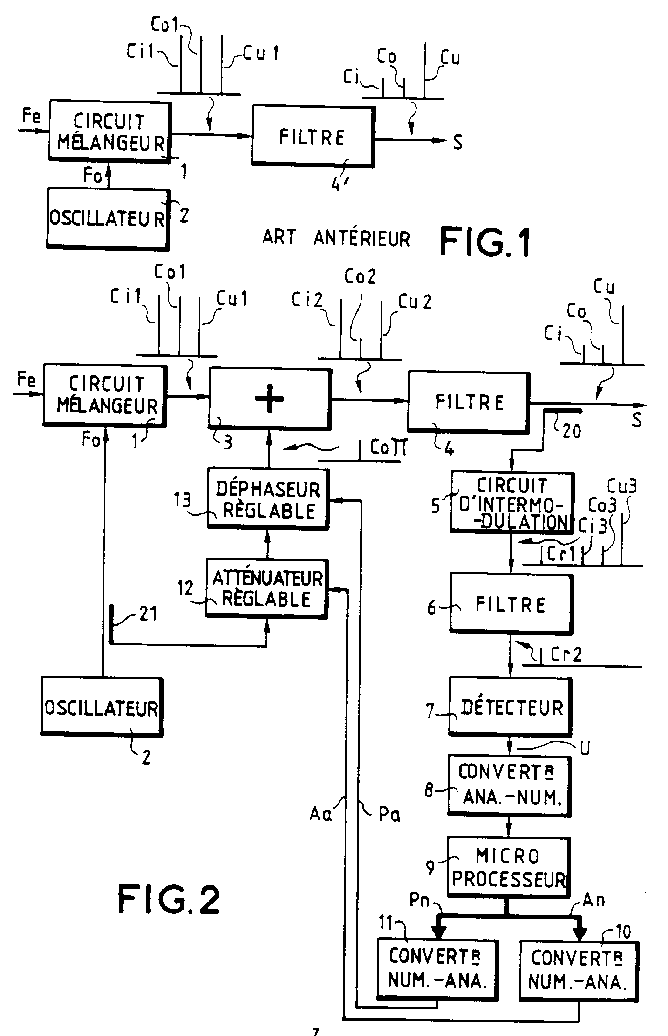

La figure 1 représente, de façon schématique, un dispositif de transposition de fréquence tel qu'il est réalisé de manière connue. Ce dispositif a pour rôle de transposer un signal d'entrée à fréquence Fe, généralement dite fréquence intermédiaire, en un signal à fréquence Fo + Fe ou Fo - Fe, grâce à un signal à fréquence fixe, Fo, dite fréquence locale. Le dispositif comporte un circuit mélangeur 1 qui reçoit sur une première entrée le signal à fréquence Fe et sur une seconde entrée le signal à fréquence fixe Fo délivré par un oscillateur local 2. Le circuit mélangeur 1 délivre sur sa sortie un signal qui comporte trois composantes : une première composante Cu1 qui sera aussi dite composante utile, une deuxième composante CO1 qui sera aussi dite composante locale et une troisième composante Ci1 qui sera aussi dite composante image ; la composante locale est à la fréquence Fo de l'oscillateur local tandis que la composante image et la composante utile sont aux fréquences Fo + Fe et Fo - Fe, et dans les exemples selon les figures 1 et 2 il est supposé que la composante utile est à la fréquence Fo + Fe et la composante image à la fréquence Fo - Fe.

Le signal de sortie du circuit mélangeur 1 est appliqué à l'entrée d'un filtre passe-bande 4′ dont le rôle est d'affaiblir fortement les deuxième et troisième composantes CO1, Ci1 ; le filtre 4′ donne donc sur sa sortie, qui constitue la sortie S du dispositif, un signal qui comporte encore les trois composantes mais, parmi ces trois composantes appelées maintenant Cu, Co et Ci, la composante utile Cu a une amplitude très nettement supérieure à celle des deux autres.

Sur la figure 1, comme d'ailleurs sur la figure 2, les composantes de certains des signaux ont été représentées sous la forme de raies d'un spectre de raies.

Le filtre 4′ du dispositif selon la figure 1 est difficile et donc cher à réaliser étant donné qu'il doit affaiblir la deuxième composante CO1 de son signal d'entrée sans affaiblir sa première composante Cu1 et que ces deux composantes sont à des fréquences assez proches.

Le schéma selon la figure 2 montre comment le filtrage de sortie d'un dispositif de transposition de fréquence peut être simplifié par une réduction préalable de la composante locale qui fait que le filtre de sortie du dispositif n'a plus à filtrer que la composante image dont l'écart de fréquence avec la composante utile est deux fois supérieur à l'écart entre les composantes utile et locale.

Dans le schéma selon la figure 2, les trois composantes utile, locale et image sont aussi présentes et, à différents endroits, elles sont représentées sous la forme de spectres de raies ; afin de les distinguer en fonction des traitements subis par le signal qui les comporte, ces trois composantes, ainsi que d'autres qui seront décrites plus loin, sont suivies d'un chiffre ou de la lettre ¶ sauf à la sortie du dispositif de transposition de fréquence où les composantes utile, locale et image sont simplement repérées Cu, Co, Ci.

La figure 2 montre un circuit mélangeur 1 qui reçoit sur une première entrée le signal à fréquence intermédiaire Fe et sur une seconde entrée le signal à fréquence fixe Fo délivré par un oscillateur local 2. Le signal de sortie du circuit 1 est appliqué à la première entrée d'un circuit additionneur 3 dont la sortie est reliée à l'entrée d'un filtre passe-bande 4. La sortie du filtre 4 est réunie à la sortie S du dispositif par un circuit de couplage d'énergie 20 qui prélève une très faible partie de l'énergie de sortie du filtre 4 pour l'appliquer à l'entrée d'un circuit d'intermodulation 5.

Le circuit d'intermodulation 5 est suivi, en série, d'un filtre passe-bande 6, d'un détecteur 7, d'un convertisseur analogique-numérique 8 et d'un microprocesseur 9. Le microprocesseur 9 fournis deux signaux An et Pn qui sont respectivement appliqués à deux convertisseurs numériques-analogiques 10, 11.

Les signaux de sortie Aa et Pa des convertisseurs 10, 11 servent respectivement de signaux de commande à un atténuateur réglable 12 et à un déphaseur réglable 13. Un circuit de couplage 21 prélève une partie de l'énergie à la fréquence Fo délivrée par l'oscillateur local 2, et la fournit à l'atténuateur 12 ; la sortie de l'atténuateur 12 est reliée à l'entrée de signal du déphaseur 13 dont la sortie est reliée à la seconde entrée du circuit additionneur 3.

La partie de l'énergie de l'oscillateur local 2, prélevée par le circuit de couplage 21, est atténuée dans l'atténuateur réglable 12 et déphasée dans le déphaseur réglable 13, pour donner sur la seconde entrée du circuit additionneur 3 un signal Co¶, constitué d'une composante unique à la fréquence Fo ; ce signal est sommé au signal de composantes Cu1, Co1, Ci1 sortant du circuit mélangeur 1.

Le signal Aa de commande de l'atténuateur 12 et le signal Pa de commande du déphaseur 13 sont tels qu'ils permettent d'ajuster la phase et l'amplitude du signal Co¶ de façon que ce dernier signal soit sensiblement de même amplitude que la composante locale Co1 à la sortie du circuit 1 mais déphasé de 180 degrés par rapport à cette composante.

Ainsi, par sommation, Co1 et Co¶ tendent à s'annuler. Co2 représente le résidu de composante locale à la sortie du circuit additionneur 3. La puissance de la composante Co2 dépend de la précision du réglage de l'atténuateur 12 et du déphaseur 13.

Le signal de sortie du circuit additionneur 3 comporte la composante utile, Cu2, la composante locale, Co2, très atténuée et la composante image, Ci2 ; ce signal est filtré par le filtre passe-bande 4 qui est centré sur la fréquence de la composante utile et qui atténue uniquement, parmi les trois composantes, la composante image. Les composantes du signal de sortie du filtre 4 sont notées Cu, Co et Ci.

La partie de l'énergie prélevée par le circuit de couplage 20, à la sortie du filtre 4, est amplifiée dans le circuit d'intermodulation 5. Le circuit 5 est constitué, dans l'exemple décrit, par un amplificateur travaillant à son niveau de saturation. Le circuit 5 génère un signal avec les composantes utile Cu3, locale Co3 et image Ci3, ainsi que des produits intermodulation dont un est particulièrement intéressant puisqu'il se situe à la fréquence du signal à fréquence intermédiaire Fe et que sa puissance est proportionnelle à la puissance de la composante locale Co à la sortie du filtre 4 ; la composante relative à ce produit d'intermodulation est notée Cr1.

Le filtre passe-bande 6 est centré sur la fréquence Fe de manière à délivrer sur sa sortie un signal comportant uniquement une composante Cr2 à la fréquence Fe. Le détecteur 7 qui reçoit le signal de composante Cr2, fournit donc une tension, U, proportionnelle à la puissance de la composante Co à la sortie du filtre 4. Cette tension U est convertie sous forme numérique par le convertisseur analogique-numérique 8, pour être délivrée au microprocesseur 9.

Le microprocesseur 9 génère les signaux An et Pn qui, après conversion de numérique en analogique, donnent respectivement le signal Aa de commande de l'atténuateur 12 et le signal Pa de commande du déphaseur 13.

Le programme pour l'élaboration, par le microprocesseur 9 des signaux An et Pn en fonction de la tension U convertie en numérique, se décompose en deux parties.

Pendant la première partie, à la mise sous tension du dispositif, le programme génère toutes les combinaisons possibles entre An et Pn ; pour chaque couple An-Pn envoyé sur les convertisseurs 11 et 12 et donc sur l'atténuateur réglable 12 et le déphaseur réglable 13, le convertisseur 8 fournit au microprocesseur 9 la valeur numérique de la tension U relative au couple considérée.

Un de ces couples correspond à une tension U minimum ; les deux signaux qui composent ce couple pour lequel U est minimum, sont envoyés, en permanence, respectivement sur les convertisseurs 10 et 11 pour commander l'atténuateur 12 et le déphaseur 13. Et ce réglage de U à sa valeur minimum est l'assurance que la puissance de la composante locale Co à la sortie du filtre 4, est réduite à sa valeur minimum.

Pendant la deuxième partie il est nécessaire de corriger dès qu'elles se produisent, les variations de puissance de la composante image à la sortie du filtre 4 ; de telles variations peuvent résulter de variations de température ou d'un vieillissement du matériel. Pour effectuer cette correction le programme comporte une mesure permanente de la tension U. Si U s'écarte de sa valeur minimum, le programme fait varier le couple An-Pn autour des valeurs An et Pn précédemment obtenues et mesure, pour chaque nouveau couple, la valeur de U ; lorsqu'une nouvelle tension U minimum est trouvée, le microprocesseur 9 envoie en permanence le nouveau couple correspondant à cette nouvelle tension minimum. Ainsi le dispositif est bouclé en permanence.

Le dispositif de transposition de fréquence qui a servi d'exemple pour la description selon la figure 2 fonctionnait avec une fréquence Fe de 15 MHz et une fréquence locale pouvant prendre des valeurs allant de 350 à 700 MHz. Le convertisseur 8 était un convertisseur à huit bits et les convertisseurs 10, 11 des convertisseurs à quatorze bits. La réjection de la composante locale Co à la sortie du filtre 4, mesurée par rapport au niveau de la composante utile Cu à la sortie de ce même filtre, est de 50 dB dans toute la bande des fréquences de travail.

La présente invention n'est pas limitée à l'exemple décrit, c'est ainsi, en particulier, que la première partie du programme peut consister à mettre en mémoire, pour les différentes valeurs de fréquences que peuvent prendre les signaux d'entrée du circuit mélangeur, des couples de signaux An-Pn, donnant une valeur U minimum ; à la mise sous tension du dispositif la deuxième partie du programme sera immédiatement déclenchée à partir du couple mis en mémoire qui correspond aux valeurs données aux fréquences Fe et Fo.

D'une manière très générale le domaine de l'invention est constitué par toutes les transpositions de fréquence où, avant le filtrage de sortie, la composante locale est fortement affaiblie par addition, au signal de sortie du circuit mélangeur, d'un signal qui, par rapport à la composante locale de ce signal de sortie, a la même amplitude mais est déphasé de 180 degrés.

## Revendications

1. Procédé de transposition d'une fréquence qui sera dite fréquence intermédiaire (Fe) par une fréquence qui sera dite fréquence locale (Fo) pour obtenir une fréquence utile, consistant à mélanger un signal à fréquence intermédiaire et un signal à fréquence locale pour donner un signal résultant comportant une première composante à la fréquence utile, une deuxième composante à la fréquence locale et une troisième composante qui est une image de la première composante par rapport à la deuxième composante, et à effectuer un filtrage passe-bande du signal résultant, caractérisé en ce qu'il consiste également à ajouter, avant filtrage, au signal résultant, un signal de correction correspondant à la deuxième composante déphasée de 180° et, pour cela, à prélever une partie du signal après filtrage, à créer par intermodulation à partir du signal prélevé une composante auxiliaire à la fréquence intermédiaire, à prélever une partie du signal à fréquence locale et, en fonction de la valeur de la composante auxiliaire, à amplifier et déphaser le signal à fréquence locale prélevé, pour en faire le signal de correction.

2. Dispositif de transposition d'un premier signal à une fréquence qui sera dite fréquence intermédiaire par un deuxième signal à une fréquence qui sera dite fréquence locale pour obtenir un signal à une fréquence qui sera dite fréquence utile, comportant un oscillateur local (2) pour fournir le deuxième signal, un circuit mélangeur (1) pour mélanger le premier et le deuxième signal et fournir un signal résultant comportant une première composante à la fréquence utile, une deuxième composante à la fréquence locale et une troisième composante qui est une image de la première composante par rapport à la deuxième composante et un filtre de sortie (4) pour recevoir le signal résultant et en extraire la première composante, caractérisé en ce qu'il comporte des premiers moyens (20, 5, 6) couplés à la sortie du filtre de sortie pour créer, par intermodulation, une composante auxiliaire (Cr2) à la fréquence intermédiaire, des deuxièmes moyens (7, 8) pour donner une mesure de la valeur de la puissance de la composante auxiliaire et des troisièmes moyens (3, 9-13, 21) pour capter une partie du deuxième signal et l'atténuer et la déphaser avant de l'additionner au signal résultant, l'atténuation et le déphasage étant réglés de manière à rendre la valeur mesurée minimum.

3. Dispositif selon la revendication 2, caractérisé en ce que les premiers moyens comportent en série un circuit de couplage d'énergie (20) couplé à la sortie du filtre de sortie (4), un amplificateur (5) travaillant à son niveau de saturation et un filtre passe-bande (6) centré sur la fréquence intermédiaire.

4. Dispositif selon la revendication 2, caractérisé en ce que les deuxièmes moyens comportent un circuit de détection (7).

5. Dispositif selon la revendication 2, caractérisé en ce que les troisièmes moyens comportent un microprocesseur (9) pour recevoir la valeur mesurée et commander l'atténuation et le déphasage.

## Patentansprüche

1. Verfahren zur Umsetzung einer Frequenz, die Zwischenfrequenz (Fe) genannt wird, mit einer Frequenz, die lokale Frequenz (Fo) genannt wird, um eine Nutzfrequenz zu erhalten, wobei ein Zwischenfrequenzsignal und ein Signal mit der lokalen Frequenz gemischt werden, um ein Signal zu ergeben, das eine erste Komponente bei der Nutzfrequenz, eine zweite Komponente bei der lokalen Frequenz und eine dritte Komponente besitzt, die ein Bild der ersten Komponente bezüglich der zweiten Komponente ist, und wobei das resultierende Signal in einem Bandpaßfilter gefiltert wird, dadurch gekennzeichnet, daß das Verfahren weiter darin besteht, vor dem Filtern dem resultierenden Signal ein Korrektursignal entsprechend der um 180° phasenverschobenen zweiten Komponente hinzuzufügen und hierzu einen Teil des Signals nach dem Filtern zu entnehmen, durch Intermodulation ausgehend von dem entnommenen Signal eine Hilfskomponente bei der Zwischenfrequenz zu erzeugen, einen Teil des Signals mit der lokalen Frequenz zu entnehmen und abhängig vom Wert der Hilfskomponente zu verstärken und in der Phase zu verschieben, um daraus das Korrektursignal zu bilden.

2. Vorrichtung zur Umsetzung eines ersten Signals einer Frequenz, die Zwischenfrequenz genannt wird, mit Hilfe eines zweiten Signals einer Frequenz, die lokale Frequenz genannt wird, um ein Signal einer Frequenz zu erhalten, die Nutzfrequenz genannt wird, mit einem örtlichen Oszillator (2), der das zweite Signal liefert, einer Mischstufe (1), um das erste und das zweite Signal zu mischen und ein resultierendes Signal zu liefern, das eine erste Komponente bei der Nutzfrequenz, eine zweite Komponente bei der lokalen Frequenz und eine dritte Komponente besitzt, die ein Bild der ersten Komponente bezüglich der zweiten Komponente ist, und mit einem Ausgangsfilter (4), das das resultierende Signal empfängt und daraus die erste Komponente entnimmt, dadurch gekennzeichnet, daß die Vorrichtung erste Mittel (20, 5, 6), die an den Ausgang des Ausgangsfilters angeschlossen sind, um durch Intermodulation eine Hilfskomponente (Cr2) mit der Zwischenfrequenz zu erzeugen, zweite Mittel (7, 8), um ein Maß für den Wert der Leistung der Hilfskomponente zu ergeben, und dritte Mittel (3, 9 bis 13, 21) enthält, um einen Teil des zweiten Signals aufzunehmen, dann zu dämpfen und in der Phase zu verschieben, ehe dieser Teil dem resultierenden Signal hinzugefügt wird, wobei die Dämpfung und die Phasenverschiebung so geregelt werden, daß der gemessene Wert einen Mindestwert annimmt.

3. Vorrichtung nach Anspruch 2, dadurch gekennzeichnet, daß die ersten Mittel in Reihe eine Energiekopplungsschaltung (20), die an den Ausgang des Ausgangsfilters (4) gekoppelt ist, einen Verstärker (5), der auf seinem Sättigungspegel arbeitet, und ein Bandpaßfilter (6) aufweisen, das auf die Zwischenfrequenz zentriert ist.

4. Vorrichtung nach Anspruch 2, dadurch gekennzeichnet, daß die zweiten Mittel eine Detektorschaltung (7) enthalten.

5. Vorrichtung nach Anspruch 2, dadurch gekennzeichnet, daß die dritten Mittel einen Mikroprozessor (9) enthalten, der den gemessenen Wert empfängt und die Dämpfung und die Phasenverschiebung steuert.

## Claims

1. Method of transposing a frequency which will be called intermediate frequency (Fe) by a frequency which will be called local frequency (Fo) in order to obtain a useful frequency, consisting in mixing a signal at intermediate frequency and a signal at local frequency to give a resultant signal including a first component at the useful frequency, a second component at the local frequency and a third component which is an image of the first component with respect to the second component, and in carrying out a bandpass filtering of the resultant signal, characterised in that it consists also in adding to the resultant signal, before filtering, a correction signal corresponding to the second component phase-shifted by 180° and, to this end, in picking up a part of the signal after filtering, in creating by intermodulation of the picked-up signal an auxiliary component at the intermediate frequency, in picking up a part of the signal at the local frequency and, depending on the value of the auxiliary component, in amplifying and phase-shifting the picked-up part of the signal at local frequency in order to make the correction signal therefrom.

2. Device for transposing a first signal to a frequency which will be called intermediate frequency by a second signal at a frequency which will be called local frequency in order to obtain a signal at a frequency which will be called useful frequency, including a local oscillator (2) for supplying the second signal, a mixer circuit for mixing the first and the second signal and supplying a resultant signal including a first component at the useful frequency, a second component at the local frequency and a third component which is an image of the first component with respect to the second component, an output filter (4) for receiving the resultant signal and extracting the first component therefrom, characterised in that it includes first means (20, 5, 6) coupled to the output of the output filter for creating, by intermodulation, an auxiliary component (Cr2) at the intermediate frequency, second means (7, 8) for giving a measure of the value of the power of the auxiliary component and third means (3, 9-13, 21) for picking up a part of the second signal and attenuating it and phase-shifting it before adding it to the resultant signal, the attenuation and the phase shift being adjusted so as to make the measured value a minimum.

3. Device according to claim 2, characterised in that the first means include, in series, an energy-coupling circuit (20) coupled to the output of the output filter (4), an amplifier (5) working at its saturation level and a bandpass filter (6) centered on the intermediate frequency.

4. Device according to claim 2, characterised in that the second means include a detection circuit (7).

5. Device according to claim 2, characterised in that the third means include a microprocessor (9) for receiving the measured value and controlling the attenuation and the phase shifting.
